(19) Europäisches Patentamt

European Patent Office

Office européen des brevets

(11) **EP 2 026 522 B1**

(12) **EUROPEAN PATENT SPECIFICATION**

(45) Date of publication and mention
of the grant of the patent:
**09.11.2016 Bulletin 2016/45**

(51) Int Cl.:
*H04L 27/34* (2006.01)          *H03F 3/24* (2006.01)
*H04L 25/03* (2006.01)          *H04L 27/36* (2006.01)

(21) Application number: **08013194.9**

(22) Date of filing: **22.07.2008**

(54) **Method and system for polar modulation with discontinuous phase**

Verfahren und System zur polaren Modulation mit diskontinuierlicher Phase

Procédé et système de modulation polaire avec phase discontinue

(84) Designated Contracting States:
**DE GB**

(30) Priority: **31.07.2007 US 953081 P**
**30.10.2007 US 928248**

(43) Date of publication of application:
**18.02.2009 Bulletin 2009/08**

(73) Proprietor: **Broadcom Corporation**
**Irvine, CA 92617 (US)**

(72) Inventor: **Rofougaran, Ahmadreza**
**92657 Newport Coast, California (US)**

(74) Representative: **Jehle, Volker Armin et al**
**Bosch Jehle Patentanwaltsgesellschaft mbH**
**Flüggenstrasse 13**
**80639 München (DE)**

(56) References cited:
**EP-A1- 1 035 701          EP-A2- 0 708 546**
**WO-A1-2004/100483          WO-A1-2006/117589**
**US-A- 5 535 245          US-A1- 2006 045 205**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

CROSS-REFERENCE TO RELATED APPLICATIONS/INCORPORATION BY REFERENCE

FIELD OF THE INVENTION

Certain embodiments of the invention relate to signal processing. More specifically, certain embodiments of the invention relate to a method and system for polar modulation with discontinuous phase.

BACKGROUND OF THE INVENTION

Electronic communications are becoming an increasingly common and important part of everyday life. In this regard, people are relying more and more on electronic devices for reliable and timely communication of all types of information including voice, data, and multimedia. Accordingly, as the number of electronic devices enabled for wireline and/or mobile communications continues to increase, system designer are in a constant search for ways to improve their product and ultimately sell more devices. In this regard, significant efforts exist with regard to making electronic communication devices more power efficient. For example, a large percentage of communications devices are mobile wireless devices and thus often operate on battery power. Additionally, transmit and/or receive circuitry within such mobile wireless devices often account for a significant portion of the power consumed within these devices. Moreover, in some conventional communication systems, transmitters and/or receivers are often power inefficient in comparison to other blocks of the portable communication devices. Accordingly, these transmitters and/or receivers have a significant impact on battery life for these mobile wireless devices.

EP 1 035 701 A1 discloses an envelope elimination and restoration (eer) modulator comprising look-up table means, envelope post-processing means, phase post-processing means, an envelope Digital to Analogue Converter (DAC), a phase DAC and a power amplifier.

Further limitations and disadvantages of conventional and traditional approaches will become apparent to one of skill in the art, through comparison of such systems with some aspects of the present invention as set forth in the remainder of the present application with reference to the drawings.

BRIEF SUMMARY OF THE INVENTION

A system and/or method is provided for polar modulation with discontinuous phase, substantially as shown in and/or described in connection with at least one of the figures, as set forth more completely in the claims.

According to an aspect, a method for signal processing comprises:

generating in-phase and quadrature-phase components from a modulated baseband signal;
generating, from said in-phase and quadrature-phase components, a signal representative of an amplitude of said baseband signal;
pulse shaping said in-phase and quadrature-phase components;
dividing said pulse-shaped components by said signal representative of an amplitude of said baseband signal and up-converting a signal resulting from said division; and
summing said up-converted signals and amplitude modulating a resulting sum via a quantized representation of said signal representative of said amplitude of said baseband signal.

Advantageously, the method further comprises amplifying said resulting sum via one or more power amplifiers, wherein a gain of said one or more power amplifiers is controlled via said quantized representation of said signal representative of said amplitude of said baseband signal.

Advantageously, said pulse-shaping comprises a raised cosine function.

Advantageously, the method further comprises controlling a bias point of said one or more power amplifiers utilizing said quantized representation of said signal representative of an amplitude of said baseband signal.

Advantageously, the method further comprises controlling said bias point via a binary weighted current source.

Advantageously, the method further comprises cascading a number of said power amplifiers equal to a number of quantization levels utilized for said quantized representation of said signal representative of an amplitude of said baseband signal.

Advantageously, the method further comprises determining a number of quantization levels for said quantized representation of said signal representative of an amplitude of said baseband signal based on the modulation present in said baseband signal.

Advantageously, said baseband signal is a quadrature amplitude modulated (QAM) signal.

According to an aspect, a machine-readable storage is provided having stored thereon, a computer program having at least one code section for signal processing, the at least one code section being executable by a machine for causing the machine to perform steps comprising:

generating in-phase and quadrature-phase components from a modulated baseband signal;
generating, from said in-phase and quadrature-phase components, a signal representative of an amplitude of said baseband signal;
pulse shaping said in-phase and quadrature-phase components;
dividing said pulse-shaped components by said signal representative of an amplitude of said baseband signal and up-converting a signal resulting from said division; and
summing said up-converted signals and amplitude modulating a resulting sum via a quantized representation of said signal representative of said amplitude of said baseband signal.

Advantageously, said at least one code section comprises code for amplifying said resulting sum via one or more power amplifiers, wherein a gain of said one or more power amplifiers is controlled via said quantized representation of said signal representative of said amplitude of said baseband signal.
Advantageously, said pulse-shaping comprises a raised cosine function.
Advantageously, said at least one code section comprises code for controlling a bias point of said one or more power amplifiers utilizing said quantized representation of said signal representative of an amplitude of said baseband signal.
Advantageously, said at least one code section comprises code for controlling said bias point via a binary weighted current source.
Advantageously, said at least one code section comprises code for cascading a number of said power amplifiers equal to a number of quantization levels utilized for said quantized representation of said signal representative of an amplitude of said baseband signal.
Advantageously, said at least one code section comprises code for determining a number of quantization levels for said quantized representation of said signal representative of an amplitude of said baseband signal based on the modulation present in said baseband signal.
Advantageously, said baseband signal is a quadrature amplitude modulated (QAM) signal.
According to an aspect, a system for signal processing comprises:

one or more circuits that:

generate in-phase and quadrature-phase components from a modulated baseband signal;
generate, from said in-phase and quadrature-phase components, a signal representative of an amplitude of said baseband signal;
pulse shape said in-phase and quadrature-phase components;
divide said pulse-shaped components by said signal representative of an amplitude of said baseband signal and up-converting a signal resulting from said division; and
sum said up-converted signals and amplitude modulate a resulting sum via a quantized representation of said signal representative of said amplitude of said baseband signal.

Advantageously, said one or more circuits comprise one or more power amplifiers for amplifying said resulting sum, wherein a gain of said one or more power amplifiers is controlled via said quantized representation of said signal representative of said amplitude of said baseband signal.
Advantageously, said pulse-shaping comprises a raised cosine function.
Advantageously, said one or more circuits control a bias point of said one or more power amplifiers utilizing said quantized representation of said signal representative of an amplitude of said baseband signal.
Advantageously, said one or more circuits control said bias point via a binary weighted current source.
Advantageously, said one or more circuits comprise a number of said power amplifiers cascaded in series, wherein said number of said power amplifiers is equal to a number of quantization levels utilized for said quantized representation of said signal representative of an amplitude of said baseband signal.
Advantageously, said one or more circuits determine a number of quantization levels for said quantized representation of said signal representative of an amplitude of said baseband signal based on the modulation present in said baseband signal.
Advantageously, said baseband signal is a quadrature amplitude modulated (QAM) signal.
These and other advantages, aspects and novel features of the present invention, as well as details of an illustrated embodiment thereof, will be more fully understood from the following description and drawings.

BRIEF DESCRIPTION OF SEVERAL VIEWS OF THE DRAWINGS

FIG. 1 is graph illustrating the relationship between Cartesian coordinates and polar coordinates, in connection with an embodiment of the invention.

FIG. 2 is a block diagram illustrating an exemplary wireless device, in accordance with an embodiment of the invention.

FIG. 3a is a block diagram illustrating an exemplary architecture for polar modulating a signal utilizing a digitally controlled power amplifier, in accordance with an embodiment of the invention.

FIG. 3b is a block diagram illustrating an exemplary architecture for polar modulating a signal utilizing a digitally controlled power amplifier, in accordance with an embodiment of the invention.

FIG. 4 is a flow chart illustrating the polar modulation of a carrier signal by a baseband signal, in accordance with an embodiment of the invention.

DETAILED DESCRIPTION OF THE INVENTION

Certain embodiments of the invention may be found in a method and system for polar modulation with continuous phase. In this regard, in-phase and quadrature-phase components may be generated from a modulated baseband signal, and the signal components may be utilized to generate a signal representative of the amplitude of the baseband signal. Furthermore, the signal components may be pulse shaped and the pulse-shaped components may be divided by the signal representative of the amplitude of the baseband signal. The resulting signals may be up-converted to RF, summed, and amplified, where the amplification may be controlled via a quantized representation of the signal representative of the amplitude of the baseband signal. In this regard, one or more bias points, and/or one or more binary weighted current sources coupled to one or more power amplifiers may be controlled. The pulse-shaping may comprise passing the signal components through a raised cosine filter. A number of power amplifiers equal to the number of quantization levels of the signal representative of the amplitude of the baseband signal may be utilized for the amplification. Also, the number of quantization levels may be determined based on the modulation present in the baseband signal. In various embodiments of the invention, the signal may be a QAM signal.

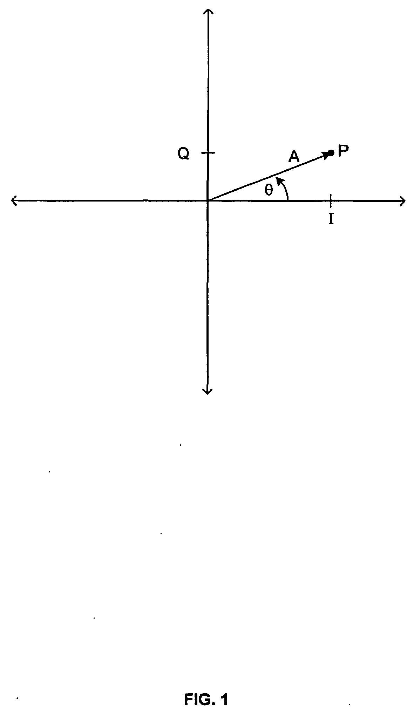

FIG. 1 is graph illustrating the relationship between Cartesian coordinates and polar coordinates, in connection with an embodiment of the invention. Polar modulation is related to quadrature modulation in the same way that the polar coordinate system is related to the Cartesian coordinate system. In a Cartesian coordinate system, a point, P, is represented by two signals of amplitudes I and Q respectively. With quadrature modulation it is often difficult to separate phase modulation from amplitude modulation and, as a result, the combined I and Q signal going to an amplifier has non-constant amplitude. Thus, signals generated with quadrature modulation often require linear amplifiers for transmission in order to preserve the integrity of the varying amplitude signal. Moreover, the linear amplifiers need to be operated at well below their 1-dB compression point. This may result in increased power consumption due to the larger conduction angles of linear power amplifiers.

In a polar coordinate system the same point, P, is represented by only one signal with magnitude R and a phase $\theta$. Polar modulation makes use of a polar coordinate system, wherein a signal is represented by a magnitude R and a phase $\theta$, allowing phase modulation and amplitude modulation to be performed independently. In this way, a polar modulated signal may be generated with one phase change and one amplitude change of one carrier signal.

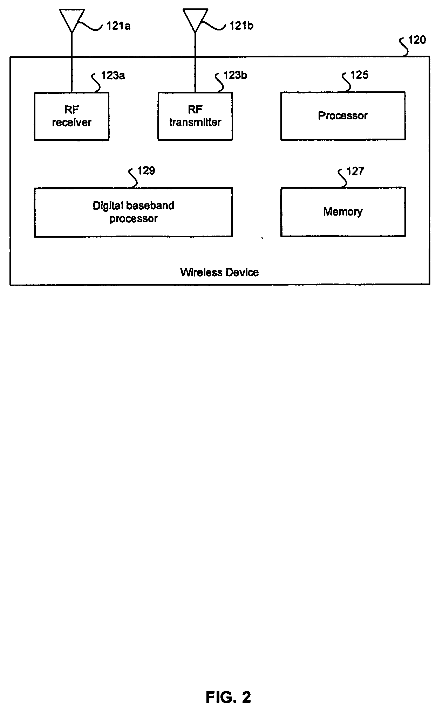

FIG. 2 is a block diagram illustrating an exemplary wireless device, in accordance with an embodiment of the invention. Referring to FIG. 2, there is shown a wireless device 120 that may comprise an RF receiver 123a, an RF transmitter 123b, a digital baseband processor 129, a processor 125, and a memory 127. A receive antenna 121 a may be communicatively coupled to the RF receiver 123a. A transmit antenna 121b may be communicatively coupled to the RF transmitter 123b.The wireless device 120 may be operated in a system, such as the cellular network and/or digital video broadcast network, for example.

The RF receiver 123a may comprise suitable logic, circuitry, and/or code that may enable processing of received RF signals. The RF receiver 123a may enable receiving RF signals in a plurality of frequency bands. For example, the RF receiver 123a may enable receiving signals in cellular frequency bands. Each frequency band supported by the RF receiver 123a may have a corresponding front-end circuit for handling low noise amplification and down conversion operations, for example. In this regard, the RF receiver 123a may be referred to as a multi-band receiver when it supports more than one frequency band. In another embodiment of the invention, the wireless device 120 may comprise more than one RF receiver 123a, wherein each of the RF receiver 123a may be a single-band or a multi-band receiver.

The RF receiver 123a may down convert the received RF signal to a baseband signal that comprises an in-phase (I) component and a quadrature (Q) component. The RF receiver 123a may perform direct down conversion of the received RF signal to a baseband signal, for example. In some instances, the RF receiver 123a may enable analog-to-digital conversion of the baseband signal components before transferring the components to the digital baseband processor 129. In other instances, the RF receiver 123a may transfer the baseband signal components in analog form.

The digital baseband processor 129 may comprise suitable logic, circuitry, and/or code that may enable processing and/or handling of baseband signals. In this regard, the digital baseband processor 129 may process or handle signals received from the RF receiver 123a and/or signals to be transferred to the RF transmitter 123b, when the RF transmitter 123b is present, for transmission to the network. The digital baseband processor 129 may also provide control and/or feedback information to the RF receiver 123a and to the RF transmitter 123b based on information from the processed signals. The digital baseband processor 129 may communicate information and/or data from the processed signals to the processor 125 and/or to the memory 127. Moreover, the digital baseband processor 129 may receive information from the processor 125 and/or to the memory 127, which may be processed and transferred to the RF transmitter 123b for transmission to the network.

The RF transmitter 123b may comprise suitable logic, circuitry, and/or code that may enable processing of RF signals for transmission. The RF transmitter 123b may enable transmission of RF signals in a plurality of frequency bands. For example, the RF transmitter 123b may enable transmitting signals in cellular frequency bands. Each frequency band supported by the RF transmitter 123b may have a corresponding front-end circuit for handling amplification and up conversion operations, for example. In this regard, the RF transmitter 123b may be referred to as a multi-band transmitter when it supports more than one frequency band. In another embodiment of the invention, the wireless device 120 may comprise more than one RF transmitter 123b, wherein each of the RF transmitter 123b may be a single-band or a multi-band transmitter.

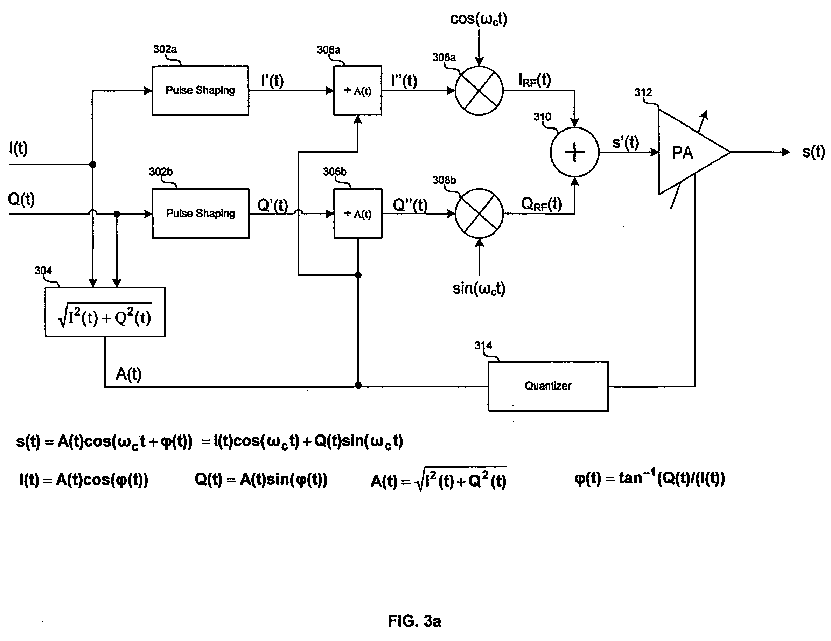

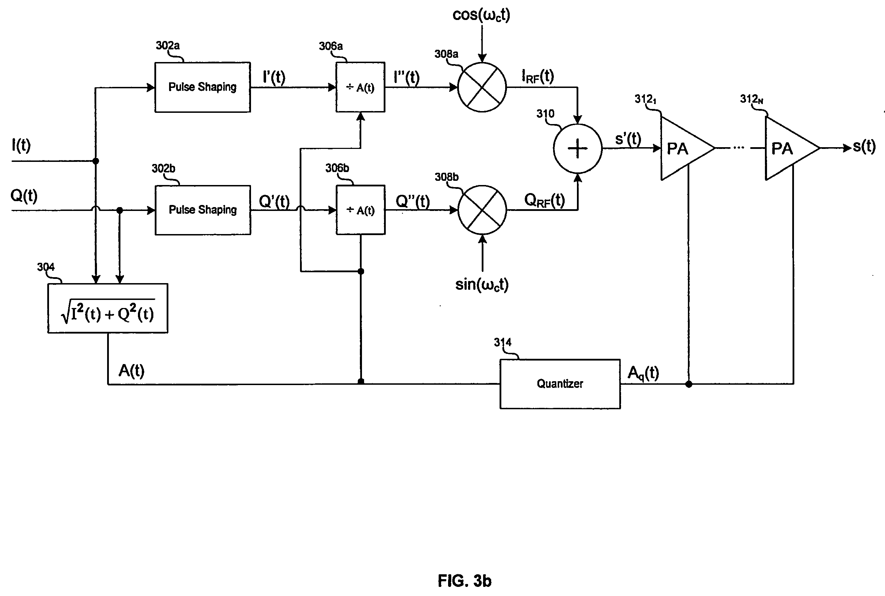

The RF transmitter 123b may quadrature up convert the baseband signal comprising I/Q components to an RF signal. The RF transmitter 123b may perform direct up conversion of the baseband signal to a RF signal, for example. In conventional systems, RF transmitters may comprise one or more power amplifier which may utilize significant amounts of power. However, the RF transmitter 123b may comprise suitable logic, circuitry, and/or code to improve the power efficiency. In this regard, the RF transmitter 123b may modulate a baseband signal onto an RF carrier as described with respect to FIGs. 3a and 3b, below. In some instances, the RF transmitter 123b may enable digital-to-analog conversion of the baseband signal components received from the digital baseband processor 129 before up conversion. In other instances, the RF transmitter 123b may receive baseband signal components in analog form.

The processor 125 may comprise suitable logic, circuitry, and/or code that may enable control and/or data processing operations for the wireless device 120. The processor 125 may be utilized to control at least a portion of the RF receiver 123a, the RF transmitter 123b, the digital baseband processor 129, and/or the memory 127. In this regard, the processor 125 may generate at least one signal for controlling operations within the wireless device 120. The processor 125 may also enable executing of applications that may be utilized by the wireless device 120. For example, the processor 125 may execute applications that may enable displaying and/or interacting with content received via cellular transmission signals in the wireless device 120.

The memory 127 may comprise suitable logic, circuitry, and/or code that may enable storage of data and/or other information utilized by the wireless device 120. For example, the memory 127 may be utilized for storing processed data generated by the digital baseband processor 129 and/or the processor 125. The memory 127 may also be utilized to store information, such as configuration information, that may be utilized to control the operation of at least one block in the wireless device 120. For example, the memory 127 may comprise information necessary to configure the RF receiver 123a to enable receiving cellular transmission in the appropriate frequency band.

FIG. 3a is a block diagram illustrating an exemplary architecture for signal processing and transmission, in accordance with an embodiment of the invention. Referring to FIG. 3a there is shown a portion of an RF transmitter comprising two pulse shaping circuits 306a and 306b, amplitude calculation block 304, division blocks 306a and 306b, mixers 308a and 308b, a summing circuit 310, a quantizer 314, and power amplifier (PA) 312.

The pulse shaping circuits 306a and 306b may comprise suitable logic, circuitry, and/r code that may enable filtering, equalizing, compressing, or otherwise processing and/or conditioning the signals I(t) and Q(t) to generate I'(t) and Q'(t), respectively. In various embodiments of the invention, the pulse shaping circuits 306a and 306b may comprise a raised cosine filter.

The amplitude calculation block 304 may comprise suitable logic, circuitry, and/or code that may enable performing the following calculation:

$$A(t) = \sqrt{I^2(t) + Q^2(t)} \qquad \text{EQ. 1}$$

where I(t) and Q(t) are in-phase and quadrature-phase, respectively, components of an input baseband signal and A(t) represents an amplitude of the input baseband signal. In various embodiments of the invention, the calculation may be carried out in the analog domain, the digital domain, or a combination thereof. In various embodiments of the invention, the amplitude calculation block 304 may comprise one or more processors or may be implemented in one or more processors.

The division or divider blocks 306a and 306b may comprise suitable logic, circuitry, and/or code that may enable dividing one baseband signal by another. In various embodiments of the invention, the calculation may be carried out in the analog domain, the digital domain, or a combination thereof. In various embodiments of the invention, the amplitude calculation block 304 may comprise one or more processors or may be implemented in one or more processors.

The mixers 308a and 308b may comprise suitable logic, circuitry, and/or code that may enable generation of inter-modulation products resulting from the mixing of a baseband signal and a RF carrier from, for example, a local oscillator. The mixer 308a may, for example, be enabled to utilize an in-phase carrier signal to generate in-phase inter-modulation products. The mixer 308b may, for example, be enabled to utilize a quadrature phase LO signal to generate quadrature phase inter-modulation products. The frequency of the carrier signals may be determined based on the desired radio frequency for transmission. In this regard, the mixers 308a and 308b may enable up-converting, for example, baseband signals of a fixed frequency to a variable radio frequency for transmission

The summing circuit 310 may comprise suitable logic, circuitry, and/or code that may enable adding an in-phase component and a quadrature-phase component to generate a phase modulate RF signal. In various embodiments of the invention, the calculation may be carried out in the analog domain, the digital domain, or a combination thereof. In various embodiments of the invention, the summing circuit 310 may comprise one or more processors or may be implemented in one or more processors.

The power amplifier (PA) 320 may comprise suitable logic, circuitry, and/or code that may enable buffering and/or amplification of a RF signal and outputting the signal to an antenna for transmission. In this regard, the gain of the PA 312 may be adjustable and may enable transmitting signals of varying strength. In this regard, the PA 312 may enable amplitude modulating an RF signal input to the PA 312. For example, the PA 312 may comprise a binary weighted current source that may enable controlling the gain. Similarly, one or more power regulators supplying the PA 312 may be controlled to alter the gain of the PA 312.

The quantizer 314 may comprise suitable logic circuitry, and/or code that may enable converting the analog signal A(t) to a digital or quantized representation. In this regard, generating A(t) from I(t) and Q(t) may result in A(t) comprising a discrete number of amplitudes. Accordingly, A(t) may be quantized without introducing significant quantization error. On the other hand, generating A(t) from I'(t) and Q'(t), may result in significant quantization error and loss of information.

In operation, a baseband signal may be split into in-phase, I(t), and quadrature-phase, Q(t), components. The signal components may be conveyed to the amplitude calculation block 304 where A(t) may be generated. In this regard, generating A(t) prior to pulse shaping I(t) and Q(t) may allow the signal A(t) to be based on the modulation without introducing additional signal variations due to the pulse shaping. Accordingly, the signal A(t) may comprise a discrete number of levels based on the modulation of the signals I(t) and Q(t). For example, in a 16-QAM modulation scheme, A(t) may comprise 4 discrete levels. Accordingly, A(t) may be quantized and the quantized signal may be utilized to control the Power Amplifier 312. For example, one or more bias points for the PA 312 may be controlled, via a binary weighted current source, by the quantized amplitude signal. In this manner, design of the power amplifier may be simplified since it only needs to operate at a discrete, and relatively small number of bias points. On the contrary, if A(t) is calculated utilizing I'(t) and Q'(t), then A(t) may become distorted and/or may comprise an increased number of amplitudes, thus increasing the complexity of the PA 312 and/or control of the PA 312.

I(t) and Q(t) may be conveyed to the pulse shaping circuits 302a and 302b, respectively, to generate I'(t) and Q'(t). Subsequently, I'(t) and Q'(t) may, respectively, be conveyed to the division blocks 306a and 306b. The division blocks 306a and 306b may divide I'(t) and Q'(t) by A(t) to generate I"(t) and Q"(t). In this regard, I"(t) and Q"(t) may comprise primarily phase information, but there may also be amplitude variations in the signals I"(t) and Q"(t) due to the pulse shaping.

I"(t) and Q"(t) may , respectively, be mixed with in-phase and quadrature-phase components of an RF carrier signal to generate $I_{RF}(t)$ and $Q_{RF}(t)$. Subsequently, $I_{RF}(t)$ and $Q_{RF}(t)$ may be summed to generate the signal s'(t), a carrier signal phase modulated by the baseband signal. Next, s'(t) may be conveyed to the PA 312. The gain of the PA 312 may be controlled via the quantized signal Aq(t) such that the transmitted signal, s(t), is a RF carrier polar modulated by the baseband signal. In one embodiment of the invention, Aq(t) may control a binary weighted current source comprising the PA 312.

FIG. 3b is a block diagram illustrating an exemplary architecture for signal processing and transmission, in accordance with an embodiment of the invention. Referring to FIG. 3b there is shown a portion of an RF transmitter comprising two pulse shaping circuits 306a and 306b, amplitude calculation block 304, division blocks 306a and 306b, mixers 308a and 308b, a summing circuit 310, a quantizer 314, and power amplifiers (PA) $312_1$ ... $312_N$.

The two pulse shaping circuits 306a and 306b, the amplitude calculation block 304, the division blocks 306a and 306b, the mixers 308a and 308b, the summing circuit 310, and the quantizer 314 may be as described with respect to FIG. 3a.

Each of the power amplifiers $312_1 ... 312_N$ may comprise suitable logic, circuitry, and/or code that may enable amplifying and/or buffering of an RF signal. Additionally, the final power amplifier $312_N$ may comprise suitable logic, circuitry, and/or code for transmitting a signal via an antenna. Each PA $312_i$ may receive a digital signal that may enable configuring the gain of the amplifier $312_i$. In this manner, the quantized amplitude signal, Aq(t) may control the overall gain of the cascaded amplifiers $312_1 ... 312_N$.

In an exemplary operation, the number of quantization levels output by the quantizer 314 may correspond to the number, N, of cascaded power amplifiers. For example, the $i^{th}$ bit output by the quantizer may control the gain of the PA $312_i$. In this manner, if the $i^{th}$ bit is asserted the PA 312 may apply a gain and it the $i^{th}$ bit is de-asserted the PA $312_1$ may simply buffer or simply pass the signal. In this regard, the design of the PAs $312_1 ... 312_N$ since each amplifier may need to only operate at a single bias point. Accordingly, by cascading 'N' PA's in series, with each PA capable of providing unity gain or gain 'G', the PAs $312_1 ... 312_N$ may be enabled to generate N output levels and thus amplitude modulate the output by the signal Aq(t).

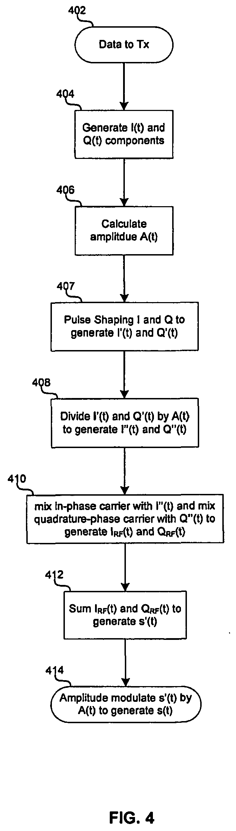

FIG. 4 is a flow chart illustrating the polar modulation of a carrier signal by a baseband signal, in accordance with an embodiment of the invention. Referring to FIG, 4 the exemplary steps may begin with step 402 when data is ready to be transmitted. The transmitted data may, for example, arrive at the RF transmitter 120b of Fig 2. Subsequent to step 402, the exemplary steps may advance to step 404. In step 404, a baseband signal may be decomposed into in-phase and quadrature phase components. Subsequent to step 404, the exemplary steps may advance to step 406. In step 406, an amplitude component of a polar modulated output may be generated. In this regard, the amplitude, A(t), may be calculated as above in EQ. 1. Subsequent to step 406, the exemplary steps may advance to step 407. In step 407, the signals I(t) and Q(t) may be passed through pulse shaping circuits to generate signals I'(t) and Q'(t).

Subsequent to step 407, the exemplary steps may advance to step 408. In step 408, I(t) and Q(t) may each be divided by A(t) to generate I'(t) and Q'(t). Subsequent to step 408, the exemplary steps may advance to step 410. In step 410, I'(t) may be mixed with an in-phase component of an RF carrier signal to generate I"(t) and Q'(t) may be mixed with a quadrature-phase component of an RF carrier signal to generate Q"(t). Subsequent to step 410, the exemplary steps may advance to step 412. In step 412, I"(t) and Q"(t) may be combined to generate a phase modulated carrier signal s'(t). Subsequent to step 412, the exemplary steps may advance to step 414. In step 414, s'(t) may be conveyed to a power amplifier for amplitude modulation and transmission. In this regard, the gain of the PA may be controlled by A(t) to effectively amplitude modulate s'(t) resulting in the polar modulated signal s(t).

Aspects of a method and system for polar modulation with discontinuous phase are provided. In this regard, in-phase and quadrature-phase components, I(t) and Q(t), may be generated from a modulated baseband signal, and the signal components may be utilized to generate a signal, A(t), representative of the amplitude of the baseband signal. Furthermore, the signal components may be pulse shaped and the pulse-shaped components, I'(t) and Q'(t), may be divided by the signal A(t). The resulting signals, I"(t) and Q"(t), may be up-converted to RF, summed, and amplified, wherein said amplification may be controlled via a quantized representation, Aq(t), of the signal representative of the amplitude of the baseband signal. In this regard, one or more bias points, and/or one or more binary weighted current sources coupled to one or more power amplifiers 312 may be controlled. The pulse-shaping may comprise passing the signal components through a raised cosine filter. A number of power amplifiers, N, equal to the number of quantization levels of said signal representative of the amplitude of the baseband signal may be utilized for the amplification. Also, the number of quantization levels may be determined based on the modulation present in the baseband signal. In various embodiments of the invention, the signal may be a QAM signal.

Another embodiment of the invention may provide a machine-readable storage, having stored thereon, a computer program having at least one code section executable by a machine, thereby causing the machine to perform the steps as described herein for polar modulation with discontinuous phase.

Accordingly, the present invention may be realized in hardware, software, or a combination of hardware and software. The present invention may be realized in a centralized fashion in at least one computer system, or in a distributed fashion where different elements are spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

**Claims**

1.   A method for signal processing, the method comprising:

generating (404) in-phase and quadrature-phase components from a modulated baseband signal;
generating (406), from said in-phase and quadrature-phase components, a signal representative of an amplitude of said baseband signal;
pulse shaping (407) said in-phase and quadrature-phase components;
dividing (408) said pulse-shaped components by said signal representative of an amplitude of said baseband signal and up-converting signals resulting from said division;
summing (412) said up-converted signals and amplitude modulating a resulting sum via a quantized representation of said signal representative of said amplitude of said baseband signal;
cascading a number of said power amplifiers equal to a number of quantization levels utilized for said quantized representation of said signal representative of the amplitude of said baseband signal;
wherein each of said number of cascaded power amplifiers is configurable into only two configurations, with each of said number of cascaded power amplifiers providing either unity gain or a predetermined gain 'G'.

2.   The method according to claim 1, comprising amplifying said resulting sum via said number of cascaded power amplifiers, wherein a gain of said number of cascaded power amplifiers is controlled via said quantized representation of said signal representative of said amplitude of said baseband signal.

3.   The method according to claim 1, wherein said pulse-shaping comprises a raised cosine function.

4.   The method according to claim 1, comprising controlling a bias point of said number of cascaded power amplifiers utilizing said quantized representation of said signal representative of an amplitude of said baseband signal.

5.   The method according to claim 4, comprising controlling said bias point via a binary weighted current source.

6.   A machine-readable storage having stored thereon, a computer program having at least one code section for signal processing, the at least one code section being executable by a machine for causing the machine to perform steps comprising:

generating in-phase and quadrature-phase components from a modulated baseband signal;
generating, from said in-phase and quadrature-phase components, a signal representative of an amplitude of said baseband signal;
pulse shaping said in-phase and quadrature-phase components;
dividing said pulse-shaped components by said signal representative of an amplitude of said baseband signal and up-converting signals resulting from said division;
summing said up-converted signals and amplitude modulating a resulting sum via a quantized representation of said signal representative of said amplitude of said baseband signal; and
cascading a number of said power amplifiers equal to a number of quantization levels utilized for said quantized representation of said signal representative of the amplitude of said baseband signal;
wherein each of said number of cascaded power amplifiers is configurable into only two configurations, with each of said number of cascaded power amplifiers providing either unity gain or a predetermined gain 'G'.

7.   A system for signal processing, the system comprising:

one or more circuits (302a, 302b, 304, 308a, 308b, 310) that are adapted to: generate in-phase and quadrature-phase components from a modulated baseband signal;
generate, from said in-phase and quadrature-phase components, a signal representative of an amplitude of said baseband signal;

pulse shape said in-phase and quadrature-phase components;

divide said pulse-shaped components by said signal representative of an amplitude of said baseband signal and up-converting signals resulting from said division; and

sum said up-converted signals and amplitude modulate a resulting sum via a quantized representation of said signal representative of said amplitude of said baseband signal; the system further comprising:

a number of cascaded power amplifiers equal to a number of quantization levels utilized for said quantized representation of said signal representative of the amplitude of said baseband signal;

wherein each of said number of said power amplifiers is configurable into only two configurations, with each of said number of said power amplifiers providing either unity gain or a predetermined gain 'G'.

8. The system according to claim 7, wherein said one or more circuits comprise said number of cascaded power amplifiers ($312_1$, ..., $312_N$) for amplifying said resulting sum, wherein a gain of said number of cascaded power amplifiers ($312_1$, ..., $312_N$) is controlled via said quantized representation of said signal representative of said amplitude of said baseband signal.

9. The system according to claim 7, wherein said pulse-shaping comprises a raised cosine function.

10. The system according to claim 7, wherein said one or more circuits is/are adapted to control a bias point of said number of cascaded power amplifiers ($312_1$ ..., $312_N$) utilizing said quantized representation of said signal representative of the amplitude of said baseband signal.

**Patentansprüche**

1. Verfahren zur Signalverarbeitung, wobei das Verfahren umfasst:

- Erzeugen (404) von Inphasen- und Quadraturphasenkomponenten aus einem modulierten Basisbandsignal,
- Erzeugen (406) eines für eine Amplitude des Basisbandsignals repräsentativen Signals aus den Inphasen- und Quadraturphasenkomponenten,
- Impulsformen (407) der Inphasen- und Quadraturphasenkomponenten,
- Dividieren (408) der impulsgeformten Komponenten durch das für eine Amplitude des Basisbandsignals repräsentative Signal und Aufwärtswandeln von aus der Division resultierenden Signalen,
- Summieren (412) der aufwärtsgewandelten Signale und Amplitudenmodulieren einer resultierenden Summe über eine quantisierte Darstellung des für die Amplitude des Basisbandsignals repräsentativen Signals,
- Kaskadieren einer Anzahl der Leistungsverstärker, die einer Anzahl Quantisierungspegel entspricht, die zur quantisierten Darstellung des für die Amplitude des Basisbandsignals repräsentativen Signals verwendet wird,
- wobei jeder der Anzahl kaskadierter Leistungsverstärker in nur zwei Konfigurationen konfigurierbar ist, wobei jeder der Anzahl kaskadierter Leistungsverstärker entweder eine Einsverstärkung oder eine vordefinierte Verstärkung 'G' bereitstellt.

2. Verfahren nach Anspruch 1, das das Verstärken der resultierenden Summe über die Anzahl kaskadierter Leistungsverstärker umfasst, wobei eine Verstärkung der Anzahl kaskadierter Leistungsverstärker über die quantisierte Darstellung des für die Amplitude des Basisbandsignals repräsentativen Signals gesteuert wird.

3. Verfahren nach Anspruch 1, wobei das Impulsformen eine Raised-Cosine-Funktion umfasst.

4. Verfahren nach Anspruch 1, das das Steuern eines Arbeitspunkts der Anzahl kaskadierter Leistungsverstärker unter Verwendung der quantisierten Darstellung des für eine Amplitude des Basisbandsignals repräsentativen Signals umfasst.

5. Verfahren nach Anspruch 4, das das Steuern des Arbeitspunkts über eine binäre gewichtete Stromquelle umfasst.

6. Maschinenlesbarer Speicher, in dem ein Computerprogramm gespeichert ist, das wenigstens einen Codeabschnitt zur Signalverarbeitung aufweist, wobei der wenigstens eine Codeabschnitt durch eine Maschine ausführbar ist, um die Maschine zu veranlassen, Schritte durchzuführen, die umfassen:

- Erzeugen von Inphasen- und Quadraturphasenkomponenten aus einem modulierten Basisbandsignal,
- Erzeugen eines für eine Amplitude des Basisbandsignals repräsentativen Signals aus den Inphasen- und Quadraturphasenkomponenten,
- Impulsformen der Inphasen- und Quadraturphasenkomponenten,
- Dividieren der impulsgeformten Komponenten durch das für eine Amplitude des Basisbandsignals repräsentative Signal und Aufwärtswandeln von aus der Division resultierenden Signalen,
- Summieren der aufwärtsgewandelten Signale und Amplitudenmodulieren einer resultierenden Summe über eine quantisierte Darstellung des für die Amplitude des Basisbandsignals repräsentativen Signals, und
- Kaskadieren einer Anzahl der Leistungsverstärker, die einer Anzahl Quantisierungspegel entspricht, die zur quantisierten Darstellung des für die Amplitude des Basisbandsignals repräsentativen Signals verwendet wird,
- wobei jeder der Anzahl kaskadierter Leistungsverstärker in nur zwei Konfigurationen konfigurierbar ist, wobei jeder der Anzahl kaskadierter Leistungsverstärker entweder eine Einsverstärkung oder eine vordefinierte Verstärkung 'G' bereitstellt.

7. System zur Signalverarbeitung, wobei das System umfasst:

- eine oder mehrere Schaltungen (302a, 302b, 304, 308a, 308b, 310), die dafür ausgelegt sind:
- Inphasen- und Quadraturphasenkomponenten aus einem modulierten Basisbandsignal zu erzeugen,
- ein für eine Amplitude des Basisbandsignals repräsentatives Signal aus den Inphasen- und Quadraturphasenkomponenten zu erzeugen,
- eine Impulsformung der Inphasen- und Quadraturphasenkomponenten durchzuführen,
- die impulsgeformten Komponenten durch das für eine Amplitude des Basisbandsignals repräsentative Signal zu dividieren und aus der Division resultierende Signale aufwärtszuwandeln, und
- die aufwärtsgewandelten Signale zu summieren und eine Amplitudenmodulation einer resultierenden Summe über eine quantisierte Darstellung des für die Amplitude des Basisbandsignals repräsentativen Signals durchzuführen, wobei das System ferner umfasst:
- eine Anzahl kaskadierter Leistungsverstärker, die einer Anzahl Quantisierungspegel entspricht, die zur quantisierten Darstellung des für die Amplitude des Basisbandsignals repräsentativen Signals verwendet wird,
- wobei jeder der Anzahl Leistungsverstärker in nur zwei Konfigurationen konfigurierbar ist, wobei jeder der Anzahl Leistungsverstärker entweder eine Einsverstärkung oder eine vordefinierte Verstärkung 'G' bereitstellt.

8. System nach Anspruch 7, wobei die eine oder mehreren Schaltungen die Anzahl kaskadierter Leistungsverstärker ($312_1$, ..., $312_N$) zum Verstärken der resultierenden Summe umfassen, wobei eine Verstärkung der Anzahl kaskadierter Leistungsverstärker ($312_1$, ..., $312_N$) über die quantisierte Darstellung des für die Amplitude des Basisbandsignals repräsentativen Signals gesteuert wird.

9. System nach Anspruch 7, wobei das Impulsformen eine Raised-Cosine-Funktion umfasst.

10. System nach Anspruch 7, wobei die eine oder mehreren Schaltungen dafür ausgelegt sind, einen Arbeitspunkt der Anzahl kaskadierter Leistungsverstärker ($312_1$, ..., $312_N$) unter Verwendung der quantisierten Darstellung des für die Amplitude des Basisbandsignals repräsentativen Signals zu steuern.

**Revendications**

1. Procédé de traitement de signal, le procédé comprenant les étapes consistant à :

générer (404) des composants en phase et en quadrature de phase à partir d'un signal de bande de base modulé ;
générer (406), à partir desdits composants en phase et en quadrature de phase, un signal représentant une amplitude dudit signal de bande de base ;
mettre en forme une impulsion (407) desdits composants en phase et en quadrature de phase ;
diviser (408) lesdits composants mis en forme d'impulsion par ledit signal représentant une amplitude dudit signal de bande de base et convertir par élévation les signaux résultant de ladite division ;
additionner (412) lesdits signaux convertis par élévation et moduler l'amplitude d'une somme résultante par l'intermédiaire d'une représentation quantifiée dudit signal représentant ladite amplitude dudit signal de bande de base ;
mettre en cascade un nombre desdits amplificateurs de puissance, égal à un nombre de niveaux de quantification utilisés pour ladite représentation quantifiée dudit signal représentant l'amplitude dudit signal de bande de base ;

dans lequel chacun dudit nombre d'amplificateurs de puissance mis en cascade peut être configuré dans seulement deux configurations, chacun dudit nombre d'amplificateurs de puissance mis en cascade fournissant soit un gain unitaire, soit un gain prédéterminé « G ».

2. Procédé selon la revendication 1, comprenant l'amplification de ladite somme résultante par l'intermédiaire dudit nombre d'amplificateurs de puissance mis en cascade, dans lequel un gain dudit nombre d'amplificateurs de puissance mis en cascade est commandé par l'intermédiaire de ladite représentation quantifiée dudit signal représentant ladite amplitude dudit signal de bande de base.

3. Procédé selon la revendication 1, dans lequel ladite mise en forme d'impulsions comprend une fonction cosinus surélevé.

4. Procédé selon la revendication 1, comprenant la commande d'un point de polarisation dudit nombre d'amplificateurs de puissance mis en cascade en utilisant ladite représentation quantifiée dudit signal représentant une amplitude dudit signal de bande de base.

5. Procédé selon la revendication 4, comprenant la commande dudit point de polarisation par l'intermédiaire d'une source de courant pondérée binaire.

6. Dispositif de stockage lisible par machine sur lequel est stocké un programme informatique ayant au moins une section de code pour un traitement de signal, l'au moins une section de code pouvant être exécutée par une machine permettant d'amener la machine à effectuer les étapes consistant à :

générer des composants en phase et en quadrature de phase à partir d'un signal de bande de base modulé ;
générer, à partir desdits composants en phase et en quadrature de phase, un signal représentant une amplitude dudit signal de bande de base ;
mettre en forme une impulsion desdits composants en phase et en quadrature de phase ;
diviser lesdits composants mis en forme d'impulsion par ledit signal représentant une amplitude dudit signal de bande de base et convertir par élévation des signaux résultant de ladite division ;
additionner lesdits signaux convertis par élévation et moduler l'amplitude d'une somme résultante par l'intermédiaire d'une représentation quantifiée dudit signal représentant ladite amplitude dudit signal de bande de base ; et
mettre en cascade un nombre desdits amplificateurs de puissance, égal à un nombre de niveaux de quantification utilisés pour ladite représentation quantifiée dudit signal représentant l'amplitude dudit signal de bande de base ;
dans lequel chacun dudit nombre d'amplificateurs de puissance mis en cascade peut être configuré dans seulement deux configurations, chacun dudit nombre d'amplificateurs de puissance mis en cascade fournissant soit un gain unitaire, soit un gain prédéterminé « G ».

7. Système de traitement de signal, le système comprenant :

un ou plusieurs circuits (302a, 302b, 304, 308a, 308b, 310) qui sont adaptés pour :

générer des composants en phase et en quadrature de phase à partir d'un signal de bande de base modulé ;
générer, à partir desdits composants en phase et en quadrature de phase, un signal représentant une amplitude dudit signal de bande de base ;
mettre en forme une impulsion desdits composants en phase et en quadrature de phase ;
diviser lesdits composants mis en forme d'impulsion par ledit signal représentant une amplitude dudit signal de bande de base et convertir par élévation des signaux résultant de ladite division ; et
additionner lesdits signaux convertis par élévation et moduler l'amplitude d'une somme résultante par l'intermédiaire d'une représentation quantifiée dudit signal représentant ladite amplitude dudit signal de bande de base ; le système comprenant en outre :

un nombre d'amplificateurs de puissance mis en cascade égal à un nombre de niveaux de quantification utilisés pour ladite représentation quantifiée dudit signal représentant l'amplitude dudit signal de bande de base ;
dans lequel chacun dudit nombre desdits amplificateurs de puissance peut être configuré dans seulement deux configurations, chacun dudit nombre desdits amplificateurs de puissance fournissant soit un gain unitaire, soit un gain prédéterminé « G ».

**8.** Système selon la revendication 7, dans lequel lesdits un ou plusieurs circuits comprennent ledit nombre d'amplificateurs de puissance mis en cascade ($312_1$, ..., $312_N$) permettant d'amplifier ladite somme résultante, dans lequel un gain dudit nombre d'amplificateurs de puissance mis en cascade ($312_1$, ..., $312_N$) est commandé par l'intermédiaire de ladite représentation quantifiée dudit signal représentant ladite amplitude dudit signal de bande de base.

**9.** Système selon la revendication 7, dans lequel ladite mise en forme d'impulsions comprend une fonction cosinus surélevé.

**10.** Système selon la revendication 7, dans lequel lesdits un ou plusieurs circuits sont adaptés pour commander un point de polarisation dudit nombre d'amplificateurs de puissance mis en cascade ($312_1$, ..., $312_N$) en utilisant ladite représentation quantifiée dudit signal représentant l'amplitude dudit signal de bande de base.

**FIG. 1**

FIG. 2

$$s(t) = A(t)\cos(\omega_c t + \varphi(t)) = I(t)\cos(\omega_c t) + Q(t)\sin(\omega_c t)$$

$$I(t) = A(t)\cos(\varphi(t)) \qquad Q(t) = A(t)\sin(\varphi(t)) \qquad A(t) = \sqrt{I^2(t) + Q^2(t)} \qquad \varphi(t) = \tan^{-1}(Q(t)/I(t))$$

FIG. 3a

EP 2 026 522 B1

FIG. 3b

402

Data to Tx

404

Generate I(t) and
Q(t) components

406

Calculate
amplitdue A(t)

407

Pulse Shaping I and Q to
generate I'(t) and Q'(t)

408

Divide I'(t) and Q'(t) by A(t)
to generate I"(t) and Q"(t)

410

mix in-phase carrier with I"(t) and mix
quadrature-phase carrier with Q"(t) to
generate $I_{RF}(t)$ and $Q_{RF}(t)$

412

Sum $I_{RF}(t)$ and $Q_{RF}(t)$ to
generate s'(t)

414

Amplitude modulate s'(t) by
A(t) to generate s(t)

**FIG. 4**

**EP 2 026 522 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1035701 A1